# EUROPÄISCHE PATENTSCHRIFT

(11) **EP 1 056 137 B1**
(45) Veröffentlichungstag und Bekanntmachung des Hinweises auf die Patenterteilung: **05.12.2007**
(21) Anmeldenummer: 00109681.7
(22) Anmeldetag: 06.05.2000
(51) Int. Cl.: H01L 31/042, H01L 31/05, H01L 31/02, H01L 27/142

(54) **Solarzelle mit einer Schutzdiode und ihr Herstellungsverfahren**
Solar cell with a protection diode and its manufacturing method
Cellule solaire avec une diode de protection et son procédé de fabrication

(30) Priorität: 11.05.1999 DE 19921545
(43) Veröffentlichungstag der Anmeldung: 29.11.2000
(73) Patentinhaber: AZUR SPACE Solar Power GmbH, 74072 Heilbronn (DE)
(72) Erfinder: Just, Hilgarth, 74360 Ilsfeld (DE)
(74) Vertreter: Stoffregen, Hans-Herbert

(56) Entgegenhaltungen:
- WO-A-99/62125
- DE-A- 3 826 721
- US-A- 4 997 491
- US-A- 5 223 043

## Beschreibung

Die Erfindung bezieht sich auf eine Solarzelle nach dem Oberbegriff des Anspruchs 1. Ferner bezieht sich die Erfindung auf ein Verfahren zur Herstellung einer Solarzelle.

In großflächigen Dioden von mehreren cm²-Flächen, wie diese Solarzellen aus Halbleitermaterial mit wenigstens einem p/n-Übergang bilden, sind Mikro-Kurzschlüsse, d. h. lokale, kleindimensionierte elektrische (ohmsche) Verbindungen über den p/n-Übergang des Halbleitermaterials oft unvermeidlich. Diese entstehen z. B. durch Oberflächenverletzungen während der Substratherstellung oder durch Dotierstoffanhäufungen z. B. an Kristallstörungen wie Versetzungen, insbesondere bei der Ausbildung von epitaxierten p/n-Übergängen bei z. B. Solarzellen der Elemente der Gruppen III-V des Periodensystems.

Zwar stören die so entstehenden Mikro-Kurzschlüsse die Funktion der Diode als Solarzelle in Flussrichtung kaum oder nur in geringem Umfang. Die Fehlstellen können jedoch bei Betrieb der Zelle in Sperrrichtung zu einer Zerstörung der Zelle führen. Sind z. B. mehrere Solarzellen oder -generatoren seriell in einem sogenannten String auf einem Solar Array miteinander verbunden, so wird bei sperrendem p/n-Übergang eines Generators - dies kann durch Abschattung bewirkt werden - der Solarstrom von der hohen String-Spannung der restlichen beleuchteten Solarzellen oder -generatoren durch die ohmschen Mikro-Kurzschlüsse gepresst. Dies kann zu einer starken lokalen Erhitzung, Umdotierung zur Niederohmigkeit, d. h. lokaler starker Entartung des Halbleiters und letztendlich zur Zerstörung der Zelle selbst führen.

Zur Vermeidung entsprechender lokaler starker Erhitzungen, sogenannten Hot-Spots, ist es bei seriell geschalteten Solarzellen bekannt, parallel zu den Solarzellen liegende Schutzdioden anzuordnen, deren Flussrichtung entgegen der der Solarzellen verlaufen

Bei Solarzellen-Strings, d. h. einem Verband von in Serie geschalteten Solarzellen oder Solarzellenmodulen können zur Erzielung einer höheren Zuverlässigkeit und der Vermeidung des Ausfalls ganzer Strings die einzelnen Solarzellen mit integralen Schutzdioden gesichert werden (siehe Lippold, Trogisch, Friedrich: Solartechnik, Berlin, Ernst, Verlag für Architektur u. Techn. Wiss. 1984, Seite 265, 266). Allerdings ist der zusätzliche Aufwand zur Verschalung zu Strings entsprechender integraler Schutzdioden, die auf den Rückseiten der einzelnen Solarzellen vorgesehen sind, erheblich, da zusätzlich elektrisch leitende Verbindungen zur Solarzellenvorderseite angebracht werden müssen.

Eine Solarzelle der eingangs genannten Art ist der DE 38 26 721 A1 zu entnehmen. Zur Ausbildung der Schutzdiode ist es erforderlich, dass zunächst auf die photoaktive Schicht eine zusätzliche Schicht aus halbleitendem Material aufgebracht wird, die sodann bereichsweise weggeätzt wird.

Aus der US-Z.: J.M. Olson et al., "A 27.3% efficient Ga0.5In0.5P/GaAs tandem solar cell", Appl.Phys.Lett. 56 (7), 1990, S. 623-625, ist eine Kaskadensolarzelle bekannt, bei der zwischen Paaren von photoaktive Zellen bildenden photoaktiven Schichten eine Tunneldiode verläuft.

Der EP 0 327 023 A1 ist eine p-i-n-Solarzelle mit einer Schottky-Schutzdiode zu entnehmen.

Aus der älteren, jedoch nicht vorveröffentlichten WO-A-99 62125 ist eine Multijunction-Solarzelle mit integrierter Schutzdiode zu entnehmen, die antiparallel zur Bottomzelle geschattet ist. Die Schutzdiode selbst wird mit dem Rückseitenkontakt der Solarzelle verbunden.

Aus der US-A-4 997 491 ist eine gattungsgemäße Solarzelle mit integrierter Schutzdiode bekannt. Zur Ausbildung der Schutzdiode wird in einem p-leitenden Germaniumsubstrat ein p/n-Übergang eindiffundiert.

Eine Multijunction-Solarzelle ist aus der US-A-5 223 043 bekannt. Um eine Gitteranpassung zwischen den einzelnen Solarzellen zu ermöglichen, verlaufen zwischen diesen Tunneldioden.

Der vorliegenden Erfindung liegt die Aufgabe zugrunde, eine Solarzelle mit integraler Schutzdiode sowie ein Verfahren zur Herstellung einer solchen_derart weiterzubilden, dass der herstellungstechnische Aufwand bei gleichzeitiger Erzielung einer hohen Zuverlässigkeit gering bleibt und die Verschaltung zu Strings keinen zusätzlichen Aufwand erfordert. Gleichzeitig soll die Ausbildung der Schutzdiode mit der Herstellung der Solarzelle selbst erfolgen.

Erfindungsgemäß wird die Aufgabe durch eine Solarzelle mit den Merkmalen des Anspruchs 1 gelöst.

Erfindungsgemäß wird die Diodenhalbleiterschicht bereichsweise von einer Schicht der Solarzelle selbst ausgebildet, wobei die photoaktiven Schichten beabstandet zu dem Bereich der Solarzelle verlaufen, der die Diodenhalbleiterschicht bildet. Ferner ist vorgesehen, dass die Schutzdiode mit ihrer Metallisierung in elektrisch leitendem Kontakt mit dem Frontkontakt verbunden ist.

In Weiterbildung der Erfindung ist die Schutzdiode gegenüber den photoaktiven Schichten der Solarzelle durch eine Isolatorschicht wie Antireflexionsschicht getrennt, entlang der sich die Metallisierung der Schutzdiode bis hin zum Frontkontakt erstrecken kann. Alternativ besteht die Möglichkeit, dass die Schutzdiode mit einem elektrisch leitenden Verbinder verbunden ist, der mit dem von dem Frontkontakt der Solarzelle ausgehenden elektrisch leitenden Verbinder verbunden ist. Auch besteht die Möglichkeit, dass die Metallisierung der Schutzdiode einerseits mit dem Frontkontakt der Solarzelle verbunden ist und andererseits von der Metallisierung selbst ein Verbinder ausgeht, der seinerseits mit einer weiteren Solarzelle elektrisch leitend verbunden ist.

Die Schutzdiode selbst kann als eine Schottky-Diode, eine MIS-Kontakt-Diode, eine Diode mit p/n-Übergang oder als metalllegierte Diode ausgebildet sein.

Schottky-Dioden sind Halbleiter-Metallkontakte, die das Verhalten einer Diode aufweisen. Wird ein Metall in Kontakt mit einem nicht entarteten, d. h. niederdotierten z. B. n-leitenden Halbleiter gebracht, so kann eine elektrische Leitung nur einer Richtung erfolgen. Das Metall einer Grenzschicht zum Halbleiter wirkt in diesem Fall wie ein p-leitender Halbleiter, der zusammen mit dem n-Halbleiter eine Schottky-Diode bildet.

MIS-Kontakt-Dioden sind ähnlich der Schottky-Kontakte, wobei der Halbleiter und das Metall durch eine dünne Isolatorschicht getrennt sind, durch die Elektronen tunneln können. Vorteil entsprechender MIS-Kontakt-Dioden ist eine bessere Reproduzierbarkeit bei der Herstellung und eine verbesserte Temperaturstabilität.

Eine Diode mit p/n-Übergang entsteht durch Umdotierung der Polarisation der Halbleiterschicht im Oberflächenbereich z. B. durch Implantation und/oder Eindiffusion eines entsprechenden Dotierstoffes zur Bildung eines lokalen Übergangs.

Metalllegierte Dioden-Kontakte sind Dioden, die durch Eindiffusion eines der Halbleiterdotierung entgegensetzten Dotierstoffes aus dem Metallkontakt während der Sinterung oder des Legierens entstehen, wodurch ein p/n-Übergang im Halbleiter erzeugt wird.

Erfindungsgemäß ist vorgesehen, dass zwischen den photoaktiven Schichten und dem frontseitigen Bereich des Substrats oder der Substratschicht mit der Polarität der frontseitigen photoaktiven Schicht die Tunneldiode bildende Schichten verlaufen. Eine entsprechende Tunneldiode ist zusätzlich dann vorgesehen, wenn der frontseitige Bereich des Substrats als photoaktiver Bereich ausgebildet ist, so dass durch die Tunneldiode der substratseitig ausgebildete photoaktive Bereich von dem Bereich getrennt ist, aus dem die Diodenhalbleiterschicht ausgebildet ist. In diesem Fall sichert die Schutzdiode allerdings allein die frontseitige Solarzellendiode.

In Weiterbildung der Erfindung wird vorgeschlagen, dass die Solarzelle eine Kaskadensolarzelle aus mehreren übereinanderliegenden seriell durch Tunneldioden verbundenen photoaktiven Schichten gleicher Polarität, z. B. Tandemsolarzelle mit ersten und zweiten photoaktiven Schichten ist, dass zwischen den ersten frontseitigen und den zweiten substratseitigen photoaktiven Schichten eine erste Tunneldiode und zwischen dem Substrat oder der auf diesem aufgetragenen oder ausgebildeten Schicht und den zweiten substratseitigen photoaktiven Schichten eine zweite Tunneldiode verlaufen.

Weist das Material des Substrats gegenüber der frontseitig verlaufenden photoaktiven Schicht eine gleiche Polarität auf, so ist die eine der frontseitig verlaufenden photoaktiven Schicht entsprechende Polarität aufweisende und die Diodenhalbleiterschicht bildende Schicht bildender frontseitiger Bereich des Substrats oder die auf diesem aufgetragene oder aus diesem ausgebildete Schicht gleicher Polarität gegenüber dem Substrat über eine weitere Tunneldiode getrennt.

Ein Verfahren zur Herstellung einer Solarzelle ergibt sich aus dem Anspruch 9.

Dabei ist insbesondere vorgesehen, dass vor dem bereichsweise Freilegen der leiterzwischenschicht auf die frontseitige photoaktive Schicht der elektrische Frontkontakt ausgebildet wird.

Die Metallisierung der Schutzdiode wird unmittelbar mit dem Frontkontakt oder über einen von diesem ausgehenden elektrisch leitenden Verbinder elektrisch leitend verbunden, der seinerseits mit weiteren Solarzellen verbunden wird.

Nach einer bevorzugten Ausbildung der Erfindung ist vorgesehen, dass eine Stufe zwischen dem freigelegten Bereich der Halbleiterzwischenschicht und den front- und substratseitigen photoaktiven Schichten ausgebildet wird, die mit einer vorzugsweise als Antireflexionsschicht wirkenden Isolierschicht versehen wird, entlang der zumindest bereichsweise die Metallisierung zu dem Frontkontakt hin verläuft.

Insbesondere ist vorgesehen, dass die Schutzdiode als Schottky-Diode, MIS-Kontaktdiode, p/n-Kontaktdiode oder metalllegierter Diodenkontakt ausgebildet wird.

Ein weiterer Vorschlag der Erfindung sieht vor, dass das Substrat frontseitig photoaktiv z.B. durch Eindiffusion eines p/n-Übergangs ausgebildet wird und sich auf dem p/n-Übergang die Halbleiterzwischenschicht erstreckt, auf die die Tunneldiode sowie die substrat- und frontseitigen Schichten aufgebracht werden.

Eine Weiterbildung der Erfindung sieht vor, dass auf eine erste Tunneldiode erste und zweite und eventuell weitere photoaktive Schichtenpaare unterschiedlicher Polaritäten zur Bildung einer Kaskaden-Zelle aufgebracht werden, wobei zwischen den substratseitigen Schichten und den frontseitigen Schichten eine weitere Tunneldiode angeordnet bzw. ausgebildet wird.

Erfindungsgemäß wird in der Frontseite einer Solarzelle oder -generators vorzugsweise bestehend aus Verbindungen der Gruppen III-V des Periodensystems eine Schutzdiode integral ausgebildet, wobei durch epitaktisches Wachsen von photoelektrisch aktiven und inaktiven Schichten auf einem Substrat, das selbst auch zur Erzeugung von Photostrom dienen kann, die Solarzelle selbst aufgebaut wird. Zur Ausbildung der Schutzdiode wird eine Schicht zwischen der eigentlichen photoaktiven Solarzelle und dem Substrat durch epitaktisches Wachsen ausgebildet, die eine für Schottky-, MIS-, p/n- oder metalllegierte Diodenkontakte geeignete Schicht ist, die die gleiche Polarität wie die frontseitige photoaktive Schicht, also die oberste Schicht der Solarzelle aufweist. Bei entsprechender Polarität des Substrats verlaufen des Weiteren oberhalb der entsprechenden Schicht eine Tunneldiode bildende Zwischenschichten.

Durch insbesondere lokales vertikales Abätzen eines flächenmäßig kleinen Bereichs der aktiven Solarzellenschichten und der die Tunneldiode bildenden Zwischenschichten wird die freigelegte als Diodenhalbleiterschicht dienende Halbleiterzwischenschicht bereichsweise metallisiert, wodurch eine oberflächliche lokale Separierung derart erfolgt, dass sich eine auf die Fläche der Metallisierung begrenzte Diode ausbildet, die die umgekehrte Polarität zu der Zelle aufweist. Gegebenenfalls kann zur Ausbildung der gewünschten Diodenart (Schottky-Kontakt, MIS-Kontakt oder metalllegierter Diodenkontakt) eine erforderliche Isolierung bzw. Diffusion zur Erzielung der gewünschten Übergänge erfolgen.

Losgelöst hiervon kann die Metallisierung der Diode über getrennte elektrisch leitende Verbinder mit dem Frontkontakt der Zelle oder unmittelbar durch gezielte Ausbildung der Kontaktmetallisierung mit diesem verbunden werden. Dieses kann dadurch erreicht werden, dass entlang der bei dem vertikalen Ätzen ausgebildeten Stufe zwischen den photoaktiven Schichten und der gegebenenfalls vorhandenen die Tunneldiode bildenden Schichten und der die Diodenhalbleiterschicht bildenden Halbleiterzwischenschicht verlaufenden Stufe eine Isolierschicht vorgesehen ist, entlang der sich die Kontaktmetallisierung zu dem Frontkontakt hin erstreckt. Durch diese Verschaltung ergibt sich eine zu der eigentlichen Solarzelle antiparallel verbundene integrierte Schutzdiode.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: einen String von ausgeleuchteten Solarzellen,
- Fig. 2: einen String von Solarzellen, bei der eine Solarzelle abgeschattet ist,
- Fig. 3 bis 7: eine erfindungsgemäß ausgebildete Solarzelle in unterschiedlichen Herstellungsstufen,
- Fig. 8: eine zweite Ausführungsform einer erfindungsgemäßen Solarzelle und
- Fig. 9: eine dritte Ausführungsform einer erfindungsgemäßen Solarzelle.

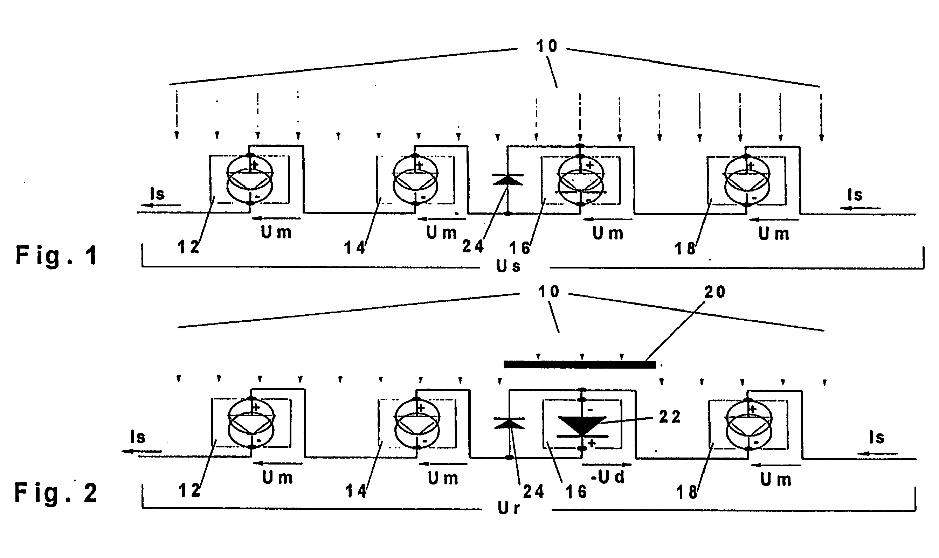

In den Fig. 1 und 2 ist rein prinzipiell ein String 10 von seriell verschalteten Solarzellen 12, 14, 16, 18 dargestellt, wobei in Fig. 1 sämtliche Solarzellen 12, 14, 16, 18 ausgeleuchtet sind. Demgegenüber ist bei dem in Fig. 2 dargestellten String 10 die Solarzelle 16 abgeschattet (Bezugszeichen 20).

Ein Solargenerator aus Halbleitermaterial mit wenigstens einem photoelektrisch aktiven p/n-Übergang der eigentlichen Solarzelle ist unbeleuchtet eine großflächige Diode, die rein beispielhaft mit dem Bezugszeichen 22 versehen ist. Wird die Solarzelle 12, 14, 16, 18 beleuchtet, wirkt diese wie ein Stromgenerator für Gleichstrom mit einem Solarstrom Iₛ, der der Intensität der Beleuchtung annähernd proportional ist und eine nahezu konstante Ausgangsspannung Uₘ aufweist, die der Flussspannung der jeweiligen Diode 22 entspricht, unter Abzug von Spannungs- und Stromverlusten aufgrund der inneren Widerstände.

In einem Solar-Array sind üblicherweise mehrere Zellen, im Ausführungsbeispiel der Fig. 1 und 2 die Zellen 12, 14, 16, 18 seriell zu dem String 10 verbunden.

Durch einen String aus n gleichmäßig beleuchteten, gleichartigen, seriell verbundenen Zellen fließt der gleiche Strom Iₛ. Die annähernd gleiche Spannung Uₘ jeder Zelle der n-Zellen des Strings addiert sich zu einer Gesamtspanne Uₛ = n * Uₘ an den Enden des Strings.

In dem String 10 beleuchteter Zellen 12, 14, 18 wird die durch Abschattung 20 unbeleuchtete Zelle 16 zu der Diode 22, an der die Restspannung des Strings 10 in Sperrrichtung anliegt, um den erzeugten Solarstrom durchzupressen. Vorhandene Mikrokurzschlüsse in den aktiven Halbleiterschichten können bei Betrieb der Zelle 16 in Sperrrichtung zu deren Zerstörung führen. Schutz gegen entsprechende Zerstörungen bieten sogenannte Bypass- oder Schutzdioden 24. Entsprechende Schutzdioden 24 sind antiparallel mit dem p/n-Übergang der abgeschatteten Zelle 16 verbundene Dioden 24, die dann, wenn der p/n-Übergang der Zelle 16 sperrt, in Flussrichtung gepolt ist und den Strom, der bei einer Spannung -U_{d}, die der Kennlinie der Schutzdiode 24 in Flussrichtung bei dem Strom entspricht, durchlässt. Somit wird die Spannung Uᵣ an den Enden des Strings durch die fehlende Spannung Uₘ der abgeschatteten Zelle (16) und die Flussspannung der Diode 24 -U_{d} vermindert, so dass Uᵣ = Uₛ - Uₘ - U_{d} ist.

Im nicht abgeschatteten Zustand der Zelle 16 sperrt der p/n-Übergang der Schutzdiode 24 den Stromfluss durch diese bei einer Sperrspannung, die der Flussspannung der zugehörigen Solarzelle 16 entspricht.

Das Ausbilden entsprechender Schutzdioden 24 an sich für Solargeneratoren auf Solar-Arrays ist zwar bekannt, jedoch nur sehr aufwendig realisierbar.

Erfindungsgemäß werden nunmehr entsprechende Schutzdioden zusammen mit der Ausbildung der Solarzellen selbst hergestellt, wodurch sich eine verfahrensmäßige Vereinfachung bei gleichzeitiger verbesserter Schutzfunktion ergibt.

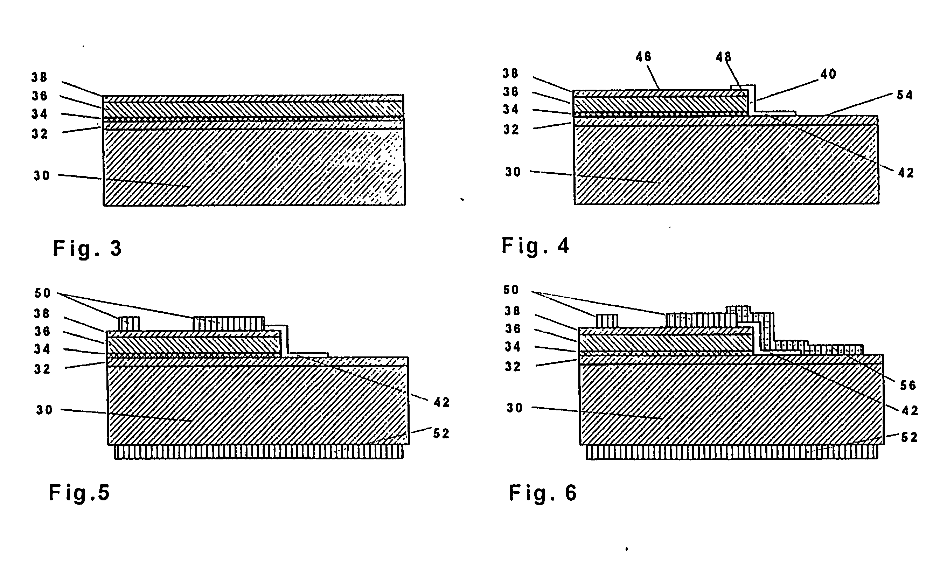

Anhand der Fig. 3 bis 9 soll die erfindungsgemäße Lehre näher erläutert werden, wobei dies am Beispiel einer Schottky-Diode als Schutzdiode erfolgt, ohne dass hierdurch eine Einschränkung erfolgen soll. Gleiches gilt in Bezug auf die Ausbildung der Solarzelle selbst sowie deren Materialien.

Die Fig. 3 bis 7 verdeutlichen prinzipiell den Verfahrensablauf zur Herstellung einer ersten Ausführungsform einer erfindungsgemäßen Solarzelle 26, von der eine Schottky-Kontaktdiode 28 als Schutzdiode ausgebildet wird.

Auf einem photoelektrisch inaktiven Substrat 30 als Träger, das zum Beispiel aus n-leitendem einkristallinen Germanium besteht, wird zunächst eine geeignete niederdotierte Halbleiter-Schicht 32 zum Beispiel in Form von Galliumarsenid aufgebracht, das mit einem geeignetem Metall einen Schottky-Kohtakt bilden kann. Dabei erfolgt die Ausbildung der niederdotierten Halbleiter-Schicht 32 durch epitaktisches Wachsen. Vorzugsweise handelt es sich bei der Halbleiter-Schicht 32 um eine niederdotierte sogenannte Bufferschicht wie Galliumarsenid-Bufferschicht, die auch dem weiteren besseren epitaktischem Wachstum dient und dieselbe Leitfähigkeit n wie das Substrat 30 aufweist. Auf die Bufferschicht 32 wird eine Halbleiter-Tunneldiode 34 epitaktisch aufgebracht, die aus zwei sehr hoch dotierten Schichten besteht, deren substratseitige Schicht n-dotiert und deren obere Schicht p-dotiert ist, um so einen niederohmigen Übergang zu einer sodann epitaktisch aufgebrachten p-leitenden Halbleiterschicht 36 zu bilden. Die p-leitende Halbleiterschicht 36 ist dabei substratseitige photoaktive Schicht oder Basis der eigentlichen Solarzellen. Sodann wird auf die p-leitende substratseitige Halbleiterschicht 36 eine n-leitende frontseitige Halbleiterschicht 38, der sogenannte Emitter aufgebracht, wodurch der p/n-Übergang zur Halbleiterschicht 36 oder Basis gebildet wird. Hierdurch sind im Beispiel der Fig. 3 die photoaktiven Schichten der Solarzelle komplettiert.

Erfindungsgemäß wird sodann ein im Vergleich zur photoempfindlichen Zellfläche kleiner Bereich der photoaktiven Schichten 38, 36, also des Emitters und der Basis sowie der Tunneldiode 34 durch zum Beispiel lokales vertikales Ätzen entfernt. Hierzu eventuell dienliche epitaktisch gewachsene photoelektrisch nicht aktive als Ätzstop-Schichten zu bezeichnende Schichten sowie andere dem besseren epitaktischen Wachstum oder der Erhöhung des photoelektrischen Wirkungsgrads dienende Epitaxieschichten wie zum Beispiel Fensterschichten oder sogenannte Cap-Schichten können den photoaktiven Schichten 36, 38, also der Basis und dem Emitter und damit der eigentlichen Solarzelle insoweit zugerechnet werden.

Durch das Entfernen wie Wegätzen der Schichten 36, 36, 34 bildet sich eine Stufe, eine sogenannte Ätzstufe 40 aus, die mit einer elektrisch isolierenden Schicht 42 abgedeckt wird. Diese Schicht 42 kann bei geeigneter Fertigungsfolge auch die zur Erhöhung des Lichteintritts in die Frontseite 44 der Solarzelle 26 üblicherweise aufgebrachte nicht leitende Antireflexionsschicht sein. Wie die Fig. 4 - 7 verdeutlichen, erstreckt sich die Isolierschicht 42 sowohl entlang der Oberfläche der als Diodenhalbleiterschicht geeigneten Halbleiterzwischenschicht 32 und der freien Außenfläche 46 der frontseitigen Halbleiterschicht 38 oder des Emitters als auch entlang der im Ausführungsbeispiel senkrecht zu den von den Schichten 32 und 38 aufgespannten Ebenen verlaufenden freigeätzten Randflächen 48 der Tunneldiode 34, der p-leitenden Basis 36 und des n-leitenden Emitters 38.

In einem sich anschließenden Verfahrensschritt werden sodann auf der Vorderseite 46 der photoaktiven Schicht 38 und damit der Solarzelle 26 und rückseitig auf dem Substrat 30 elektrisch leitende Front- und Rückseitenkontakte 50, 52 aufgebracht, die zur Entnahme des Solarstroms der Zelle 26 dienen.

Zur Ausbildung der als Schutzdiode dienenden Schottky-Diode 28 wird bereichsweise auf den freigelegten Bereich 54 der im Ausführungsbeispiel niederdotierten Halbleiterzwischenschicht 32 in Form der epitaktisch aufgewachsenen Galliumarsenid-Bufferschicht eine für einen Schottky-Kontakt geeignete Metallisierung 56 aufgebracht. Dabei ist die Metallisierung 56 in ihrer Flächenerstreckung derart gewählt, dass sich diese über die isolierte Ätzstufe, also die Beschichtung 42 zum Frontkontakt 50 hin erstreckt und damit die erforderliche elektrisch leitende Verbindung herstellt. Mit dieser Maßnahme wird die Schottky-Kontaktdiode 28 mit dem p/n-Übergang der Solarzelle 26 entgegengesetzter Polarität erzeugt, wobei gleichzeitig die elektrische Ankopplung der Schutzdiode 28 an die Solarzelle 26 selbst erfolgt.

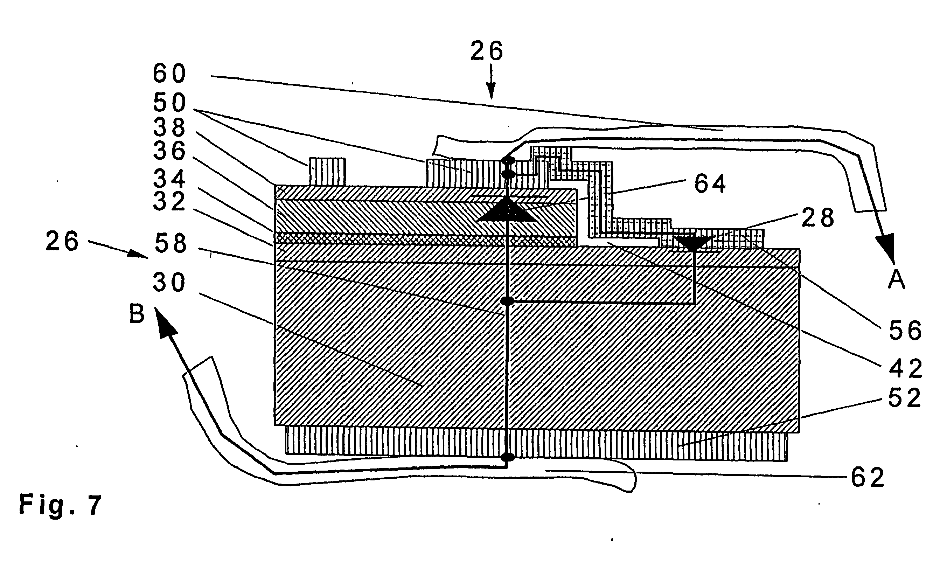

In der vergrößerten Darstellung der Solarzelle 26 in Fig. 7 ist ein Stromlaufplan 58 der Solarzelle 26 eingezeichnet, wobei ergänzend elektrisch leitende Verbinder 60, 62, die von dem Frontkontakt 50 und dem Rückseitenkontakt 52 ausgehen, dargestellt sind, um die Solarzelle 26 mit der integrierten Schutzdiode 28 mit weiteren entsprechend aufgebauten Zellen zu einem String zu verschalten. Dabei geht der Verbinder 60 zu einem Rückseitenkontakt einer vorhergehenden Solarzelle A und der Verbinder 62 zu einem Frontkontakt einer nachfolgenden Solarzelle B.

Ferner ist dem Stromlaufplan 58 und dem dargestellten Ersatzschaltbild zu entnehmen, dass die Schutzdiode 28 antiparallel zu der durch die photoaktiven Schichten 36, 38 gebildeten Diode 64 geschaltet ist, die die eigentliche Solarzelle bildet.

Sollte anstelle einer Schottky-Diode als Schutzdiode 28 eine MIS-Kontakt-Diode zum Einsatz gelangen, so würde zwischen der im Ausführungsbeispiel n-leitenden Halbleiterzwischenschicht 32 und der Metallisierung 56 eine geeignete Isolatorschicht angeordnet werden. Sofern eine metalllegierte Diode als Schutzdiode 28 benutzt werden soll, wird eine geeignete Metallkomposition als Kontaktmaterial mit nachfolgendem Sintern oder Legieren verwendet. Auch besteht die Möglichkeit, lokal einen p/n-Übergang zu erzeugen.

Die entsprechenden als Schutzdioden ausgebildeten Diodenarten können auch in Varianten des anhand der Fig. 3 - 7 erläuterten Solargenerators 26 zur Anwendung gelangen. Eine Variante ist zum Beispiel die Umkehrung aller Dotierungspolaritäten.

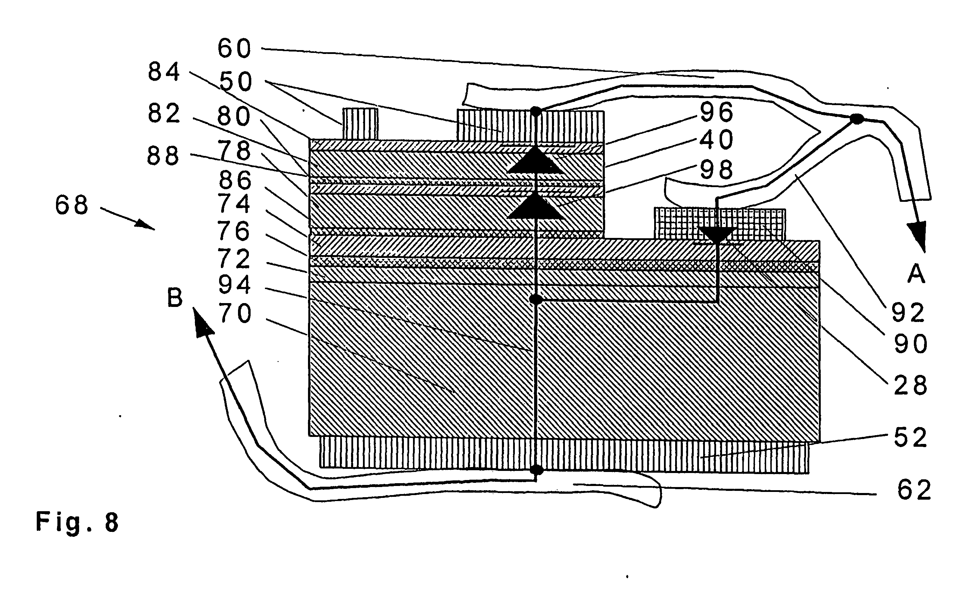

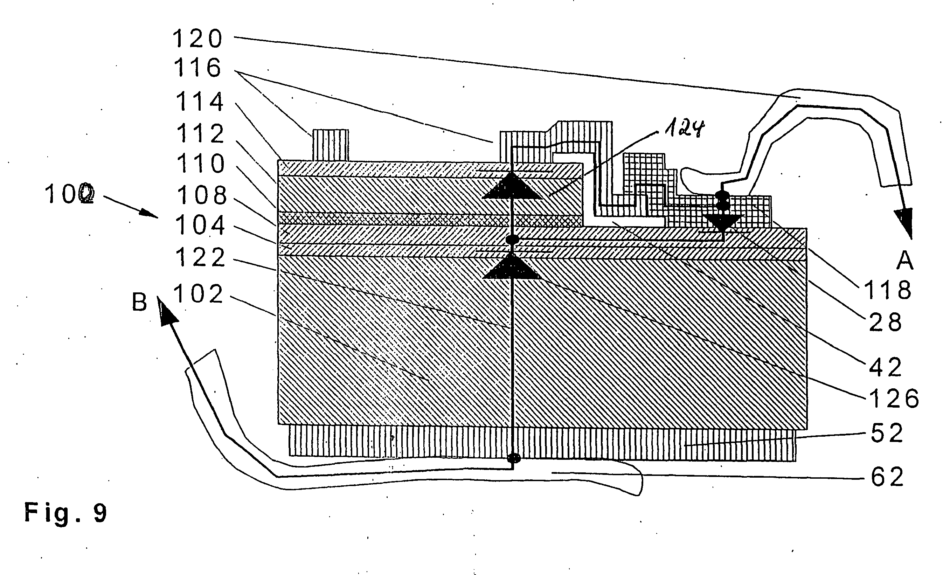

Weitere Beispiele von Modifikationen am Aufbau von Solarzellen bzw. -generatoren und dem Einsatz von Schutzdioden sollen anhand der Fig. 8 und 9 erläutert werden, ohne dass hierdurch eine Einschränkung der Erfindung erfolgt. Dabei werden für gleiche Elemente grundsätzlich gleiche Bezugszeichen verwendet.

Eine in der Fig. 8 dargestellte Solarzelle 68 weist ein Substrat 70 auf, das abweichend zu dem Substrat 30 der Solarzelle 26 eine entgegengesetzte Dotierungspolarität aufweist, also aus p-leitendem Material besteht. Auf dem Substrat 70 kann eine Bufferschicht 72 gleicher Leitungsart p aufgebracht sein. Da die Solarzelle 68 in Bezug auf ihre photoaktiven Schichten gleiche Polarität aufweist wie die Solarzelle 26, muss zwischen einer die Dioden-Halbleiterschicht bildenden n-leitenden Halbleiterzwischenschicht 74 und dem Substrat 70 bzw. dessen frontseitiger Schicht 72 eine Tunneldiode 76 ausgebildet werden, um einen niederohmigen Stromdurchgang zum Substrat 70 bzw der Bufferschicht 72 sicherzustellen. Die Tunneldiode 76 weist dabei einen Schichtaufbau auf, der umgekehrt zu dem der Tunneldiode 34 ist, also substratseitig p-dotiert und frontseitig n-dotiert ist. Auf die so ausgebildeten Substrat- und Bufferschichten 70, 72, Tunneldiode 76 und Halbleiterzwischenschicht 74 werden sodann zur Bildung von übereinander angeordneten photoaktiven Zellen erste und zweite Paare von Schichten 78, 80 und 82, 84 insbesondere epitaktisch aufgewachsen, wobei die Schichten 78, 82 p-leitende Halbleiterschichten und die Schichten 80, 84 n-leitende Halbleiterschichten sind, um hierdurch jeweils einen p/n-Übergang zwischen dem jeweiligen Emitter 80, 84 und der Basis 78, 82 auszubilden. Ferner werden zwischen dem unteren Schichtpaar 78, 80, also der Basis 78 und der Halbleiterzwischenschicht 74 eine Tunneldiode 86 und zwischen den ersten und zweiten Paaren der Schichten, also zwischen dem Emitter 80 und der Basis 82, eine weitere Tunneldiode 88 ausgebildet, deren jeweilige Schichten Polaritäten aufweisen, wie diese der Tunneldiode 34 der Solarzelle 26 entspricht, also frontseitig p-dotiert und substratseitig n-dotiert.

Sodann wird entsprechend der Verfahrensweise nach den Fig. 3 - 7 durch insbesondere lokales vertikales Abätzen die Halbleiterzwischenschicht 74, die die für die Schutzdiode 28 notwendige Diodenhalbleiterschicht bildet, freigelegt, um durch lokales Aufbringen einer Metallisierung 90 den gewünschten Schottky-Kontakt als die gewünschte Schutzdiode 28 auszubilden. Von der Metallisierung 90 geht im vorliegenden Fall ein elektrisch leitender Verbinder 92 aus, der mit dem elektrisch leitenden Verbinder 60 verbunden ist, der seinerseits von dem Frontkontakt 50 der Solarzelle 68 ausgeht. Durch die diesbezügliche Ausgestaltung ist es nicht erforderlich, dass sich entlang der durch das vertikale Ätzen ausgebildeten Stufe 40 eine Isolierschicht erstreckt.

Wie der in die Solarzelle 68 eingezeichnete Stromlaufplan 94 mit Ersatzschaltbild belegt, schützt die Schutzdiode 28 die von den photoaktiven Schichten 78, 80 und 82, 84 gebildeten zwei Dioden 96, 98.

Eine in der Fig. 9 prinzipiell dargestellte Solarzelle 100 unterscheidet sich von der der Fig. 7 dahingehend, dass in ein Substrat 102 ein p/n-Übergang 104 eindiffundiert ist, um ebenfalls zur Erzeugung von Strom benutzt zu werden. In zuvor beschriebener Weise erstreckt sich darauf eine Halbleiterzwischenschicht 108 als Diodenhalbleiterschicht, auf die wiederum eine Tunneldiode 110 und sodann weitere photoaktive Schichten 112, 114 aufgebracht werden, die einen p/n-Übergang bilden. Sodann werden die photoaktiven Bereiche 114, 112, also der Emitter und die Basis sowie die Tunneldiode 110 lokal weggeätzt, so dass die Halbleiterzwischenschicht schicht 108 freigelegt wird. Die hierdurch ausgebildete Ätzstufe 40 wird entsprechend der Fig. 7 mit der Isolierschicht 42 abgedeckt. Die sodann aufzubringenden Frontkontakte 116 weisen in Bezug auf die Solarzelle 26 der Fig. 7 eine abweichende Anordnung derart auf, dass diese bereichsweise entlang der Isolierschicht 42 verlaufen. Sodann wird auf einen freigelegten Bereich der Halbleiterzwischenschicht 108 die erforderliche Metallisierung 118 aufgebracht, die sich bis zu dem entlang der Isolierschicht 42 verlaufenden Frontkontaktmaterial erstreckt, so dass sich die erforderliche elektrisch leitende Verbindung ergibt. Ein elektrisch leitender Verbinder 120 geht sodann von der Metallisierung 118 aus, um mit dem Rückkontakt einer vorausgehenden Solarzelle A verbunden zu werden. Da der Frontkontakt 116 mit der Metallisierung 118 unmittelbar verbunden ist, braucht von dem Frontkontakt 116 selbst kein entsprechender Verbinder 120 auszugehen. Von dem Rückkontakt 52 geht entsprechend dem zuvor erläuterten Ausführungsbeispiel der weitere Verbinder 62 aus, der zur Frontseite einer nachfolgenden Solarzelle führt. Nachfolgende und vorangehende Solarzellen oder -generatoren sind selbstverständlich relativ zu verstehen.

Wie der Stromlaufplan 122 für die Zelle 100 belegt, schützt die Schutzdiode 28 allein die aus den photoaktiven Schichten 112, 114 gebildete Diode 124 und nicht den photoaktiven Bereich, der durch die innerhalb des Substrats 102 eingezeichnete Diode 126 gebildet wird.

Zweckmäßigerweise sollten die erfindungsgemäßen Zellen derart geometrisch ausgebildet sein, dass die Schutzdiode 28 in der Nähe von Befestigungspunkten der Verbinder, die zu den anderen Zellen führen, oder in der Nähe von Stromsammelbalken des Frontkontaktes verlaufen, sofern sie nicht selbst zu denselben ausgebildet sind, um zusätzliche Verluste aktiver Zellflächen durch Metallzuleitungen zwischen den Schutzdioden 28 und den Frontkontakten zu vermeiden.

Auch ist anzumerken, dass bei größeren Zellen mehr als eine Schutzdiode ausgebildet werden kann.

## Patentansprüche

1. Solarzelle (26, 68, 100) umfassend ein Substrat (30, 70, 102), photoaktive Schichten (36, 38, 78, 80, 112, 114) unterschiedlicher Polaritäten mit zumindest einer frontseitigen und einer substratseitigen Schicht, einen Rückkontakt (52) sowie einen Frontkontakt (50, 116), wobei das Substrat Träger der photoaktiven Schichten sowie einer solarzellenfrontseitig verlaufenden integrierten Schutzdiode (28) mit einer der Solarzelle entgegengerichteten Polarität ist und die Schutzdiode zumindest eine Schicht (32, 74, 108) aus Halbleitermaterial umfasst und mit dem Frontkontakt verbunden ist,
**dadurch gekennzeichnet,**
**dass** zwischen den stromerzeugenden photoaktiven Schichten (36, 38, 78, 80, 112, 114) und dem frontseitigen Bereich des Substrats (30, 70, 102) eine Tunneldiode (34, 86, 110) verläuft, die im unmittelbaren Bereich der Schutzdiode (28) lateral weggelassen ist, und dass auf dem Substrat eine epitaktisch aufgetragene Halbleiterzwischenschicht (32, 74, 108) sowohl unmittelbar unterhalb der photoaktiven Schichten als auch außerhalb von diesen verläuft, wobei der außerhalb der photoaktiven Schichten verlaufende Bereich die zumindest eine Schicht (32, 72, 108) der Schutzdiode ist.

2. Solarzelle nach Anspruch 1,
**dadurch gekennzeichnet,**
**dass** die Schutzdiode (28) eine Schottky-Diode, MIS-Kontakt-Diode, p/n-diffundierteKontakt-Diode oder Metalllegierungs-Kontakt-Diode ist.

3. Solarzelle nach Anspruch 1 oder 2,
**dadurch gekennzeichnet,**
**dass** die photoaktiven Schichten (36, 38, 112, 114) der Solarzelle (26, 100) gegenüber der Schutzdiode (28) bzw. deren Metallisierung (56, 118) durch eine elektrisch isolierende Schicht wie Antireflexionsschicht (42) getrennt sind und dass vorzugsweise sich entlang der elektrisch isolierenden Schicht (42) zumindest abschnittsweise die Metallisierung (56, 118) der Schutzdiode (28) erstreckt und/oder sich die Metallisierung (56) der Schutzdiode (28) entlang der elektrisch isolierenden Schicht (42) bis hin zu dem Frontkontakt (50) der Solarzelle (26) erstreckt.

4. Solarzelle nach zumindest einem der vorhergehenden Ansprüche,
**dadurch gekennzeichnet,**
**dass** sich der Frontkontakt (116) der Solarzelle (100) bereichsweise entlang der elektrisch isolierenden Schicht (42) erstreckt und unmittelbar mit der Metallisierung (118) der Schutzdiode (28) verbunden ist und/oder dass von dem Frontkontakt (50) und/oder der Metallisierung (90, 118) ein elektrisch leitender Verbinder (60, 92, 120) ausgeht, der zu einem Rückkontakt einer weiteren Solarzelle führt.

5. Solarzelle nach zumindest einem der vorhergehenden Ansprüche,
**dadurch gekennzeichnet,**
**dass** die Solarzelle (68) eine Kaskadensolarzelle mit wenigstens ersten frontseitigen und zweiten substratseitigen photoaktiven Schichten (82, 84, 78, 80) ist und dass zwischen den zweiten substratseitigen photoaktiven Schichten und dem Substrat (70) die die Diodenhalbleiterschicht bildende Halbleiterzwischenschicht (72) der der frontseitigen photoaktiven Schicht entsprechenden Polarität verläuft, wobei zwischen Solarzellen bildenden Paaren von photoaktiven Schichten (82, 84; 78, 80) jeweils eine Tunneldiode (88) angeordnet ist.

6. Solarzelle nach zumindest einem der vorhergehenden Ansprüche,
**dadurch gekennzeichnet,**
**dass** bei einem Substrat (70) einer zu der Polarität der photoaktiven frontseitigen Schicht (84) entgegengesetzten Polarität zwischen der die Diodenhalbleiterschicht bildenden Halbleiterzwischenschicht (74) und dem Substrat eine Tunneldiode (76) verläuft.

7. Solarzelle nach zumindest einem der vorhergehenden Ansprüche,
**dadurch gekennzeichnet,**
**dass** das Substrat (102) der Solarzelle (100) in seinem frontseitigen Bereich einen p/n-Übergang (104) aufweist, über dem sich die die Diodenhalbleiterschicht bildende Halbleiterzwischenschicht (108) erstreckt, auf der außerhalb der Schutzdiode (28) eine zweite Tunneldiode (118) und die auf dieser angeordneten photoaktiven Schichten (112, 114) angeordnet sind.

8. Solarzelle nach zumindest Anspruch 1,
**dadurch gekennzeichnet,**
**dass** von der Schutzdiode (28) ein erster Verbinder (92) ausgeht, dass von dem Frontkontakt (50) der Solarzelle (68) ein zweiter Verbinder (60) ausgeht, dass der erste Verbinder mit dem zweiten Verbinder verbunden ist und mit Rückseite einer seriell mit der Solarzelle verschalteten weiteren Solarzelle verbunden ist.

9. Verfahren zur Herstellung einer Solarzelle Anspruch 8 nach zumindest einem der Ansprüche 1-8 mit folgenden Verfahrensschritten:
- epitaktisches Wachsen einer die zumindest eine Diodenhalbleiterschicht bildenden Halbleiterzwischenschicht auf gesamtem frontseitigem Bereich des Substrats einer Polarität entsprechend frontseitiger photoaktiver Schicht der Solarzelle,
- epitaktisches Wachsen einer Tunneldiode auf der Halbleiterzwischenschicht,
- epitaktisches Wachsen der substrat- und frontseitigen photoaktiven Schichten,
- bereichsweises Freilegen der Halbleiterzwischenschicht,
- Ausbilden der Schutzdiode mit der der Solarzelle entgegengerichteten Polarität unter Verwendung von freigelegtem Bereich der Halbleiterzwischenschicht durch mittelbares oder unmittelbares Aufbringen einer Metallisierung auf dieser und anschließendes Verbinden mit dem Frontkontakt.

10. Verfahren nach Anspruch 9,
**dadurch gekennzeichnet,**
**dass** insbesondere nach dem bereichsweise Freilegen der Halbleiterzwischenschicht auf der frontseitigen photoaktiven Schicht der elektrisch leitende Frontkontakt an geordnet wird, dass vorzugsweise die Metallisierung unmittelbar mit dem Frontkontakt oder über einen von diesem ausgehenden elektrisch leitenden Verbinder elektrisch leitend verbunden ist, der mit rückseitigem Kontakt einer weiteren Solarzelle verbunden wird, und/oder dass zwischen dem freizulegenden Bereich der Halbleiterzwischenschicht und den front- und substratseitigen photoaktiven Schichten eine Stufe insbesondere durch vertikales Ätzen ausgebildet wird.

11. Verfahren nach Anspruch 9 oder 10,
**dadurch gekennzeichnet,**
**dass** entlang der Stufe eine sich von der frontseitigen photoaktiven Schicht bis zu dem freigelegten Bereich der Halbleiterzwischenschicht erstreckende elektrisch isolierende Schicht wie Antireflexionsschicht ausgebildet wird.

## Claims

1. A solar cell (28, 68, 100) comprising a substrate (30, 70, 102), photoactive layers (36, 38, 78, 80, 112, 114) of different polarities having at least one layer at the front side and one at the substrate side, a back contact (52) as well as a front contact (50, 116), whereby the substrate is a carrier of the photoactive layers as well as of an integral protective diode (28) running at the front side of the solar cell and having a polarity opposite the solar cell and the protective diode comprises at least one layer (32, 74, 108) of semiconductor material and is connected with the front contact,
**characterized in**
**that** between the current-generating photoactive layers (36, 38, 78, 80, 112, 114) and the front side region of the substrate (30, 70, 102) a tunnel diode (34, 86, 110) extends, which is omitted laterally in the direct region of the protective diode (28), and that an epitaxially applied semiconductor intermediate layer (32, 74, 108) extends on the substrate both directly beneath the photoactive layers and outside the latter, whereby the region extending outside the pohotactive layers is the at least one layer (32, 72, 108) of the protective layer.

2. The solar cell according to claim 1,
**characterized in**
**that** the protective diode (28) is a Schottky diode, MIS contact diode, p/n diffused contact diode or metal-alloy contact diode.

3. The solar cell according to claim 1 or 2,
**characterized in**
**that** the photoactive layers (36, 38, 112, 114) of the solar cell (26, 100) are separated relative to the protective diode (28), or its metallizing (56, 118), by an electrically insulating layer, such as an antireflection layer (42) and that preferably along the electrically insulating layer (42) at least regionally the metallizing (56, 118) of the protective diode (28) extends and/or the metallizing (56) of the protective diode (28) extends along the electrically insulating layer (42) up to the front contact (50) of the solar cell (26).

4. The solar cell according to at least one of the preceding claims,
**characterized in**
**that** the front contact (116) of the solar cell (100) extends regionally along the electrically insulating layer (42) and is joined directly to the metallizing (118) of the protective diode (28) and/or that an electrically conductive connector (60, 92, 120) extends from the front contact (50) and/or the metallizing (90, 118) and leads to a back contact of a further solar cell.

5. The solar cell according to at least one of the preceding claims,
**characterized in**
**that** the solar cell (68) is a cascade solar cell, having at least first front side and second substrate side photoactive layers (82, 84, 78, 80), and that between the second substrate side photoactive layers and the substrate (70) the semiconductor intermediate layer (72) of the polarity corresponding to the front side photoactive layer extends forming the diode semiconductor layer, whereby between each pair of photoactive layers (82, 84; 78, 80) forming solar cells one tunnel diode (88) is arranged.

6. The solar cell according to at least one of the preceding claims,
**characterized in**
**that** in a substrate (70), having a polarity opposite the polarity of the photoactive front side layer (84), a tunnel diode (76) extends between the semiconductor intermediate layer (74), that forms the diode semiconductor layer, and the substrate.

7. The solar cell according to at least one of the preceding claims,
**characterized in**
**that** the substrate (102) of the solar cell (100), in its front side region, has a p-n junction (104), above which the semiconductor intermediate layer (108) forming the diode semiconductor layer extends, on which outside the protective diode (28) a second tunnel diode (118) and the photoactive layers (112, 114) arranged on it are arranged.

8. The solar cell according to at least claim 1,
**characterized in**
**that** from the protective diode (28) a first connector (92) extends, that from the front contact (50) of the solar cell (68) a second connector (60) extends, that the first connector is connected with the second connector and with rear side of a further solar cell being serially connected with the solar cell.

9. A method for producing a solar cell according to at least one of the claims 1-8 by way of the following method steps
- epitaxial growth of a semiconductor intermediate layer forming at least a diode semiconductor layer on the entire front side region of the substrate of a polarity corresponding to front side photoactive layer of the solar cell,
- epitaxial growth of a tunnel diode on the semiconductor intermediate layer,
- epitaxial growth of the substrate side and front side photoactive layers,
- laying the semiconductor intermediate layer regionally bare,
- forming the protective diode with the polarity opposite the solar cell using the bared region of the semiconductor intermediate layer by means of indirect or direct application of a metallizing onto it and subsequent connection with the front contact.

10. The method according to claim 9,
**characterized in**
**that** in particular after the regionally laying bare of the semiconductor intermediate layer on the front side photoactive layer the electrically conductive front contact is arranged, that preferably the metallizing is electrically conductively connected directly to the front contact or via an electrically conductive connector originating from the front contact, said connector being connected to the backside contact of a further solar cell, and/or that between the region of the semiconductor intermediate layer to be laid bare and both the front side and substrate side photoactive layers a step is formed, in particular by vertical etching.

11. The method according to claim 9 or 10,
**characterized in**
**that** along the shoulder, an electrically insulating layer such as an antireflection layer is formed, extending from the front side photoactive layer up to the region of the semiconductor intermediate layer laid bare is formed.

## Revendications

1. Pile solaire (26, 68, 100) comprenant un substrat (30, 70, 102), des couches photoactives (36, 38, 78, 80, 112, 114) de polarités différentes avec au moins une couche côté frontal et une couche côté substrat, un contact arrière (52) ainsi qu'un contact frontal (50, 116), le substrat étant le support des couches photoactives ainsi que d'une diode de protection (28) intégrée s'étendant du côté frontal de la pile solaire et ayant une polarité opposée à la pile solaire, cette diode de protection comprenant au moins une couche (32, 74, 108) composée de matériau semiconducteur et étant reliée au contact frontal,
**caractérisée en ce qu'**
entre les couches photoactives (36, 38, 78, 80, 112, 114) génératrices de courant et la zone côté frontal du substrat (30, 70, 102) s'étend une diode tunnel (34, 86, 110) qui est supprimée latéralement dans la zone immédiate de la diode de protection (28), et une couche intermédiaire semi-conductrice (32, 74, 108) déposée de manière épitaxiale aussi bien immédiatement en dessous des couches photoactives qu'à l'extérieur de celles-ci s'étend sur le substrat, sachant que la zone s'étendant à l'extérieur des couches photoactives est au moins une couche (32, 72, 108) de la diode de protection.

2. Pile solaire selon la revendication 1,
**caractérisée en ce que**
la diode de protection (28) est une diode à barrière de Schottky, une diode de contact MIS, une diode de contact à diffusion p/n ou une diode de contact en alliage métallique.

3. Pile solaire selon la revendication 1 ou 2,
**caractérisée en ce que**
les couches photoactives (36, 38, 112, 114) de la pile solaire (26, 100) sont séparées par rapport à la diode de protection (28) ou à sa métallisation par une couche électriquement isolante telle qu'une couche anti-réflexion (42), et la métallisation (56, 118) de la diode de protection (28) s'étend au moins par tronçons de préférence le long de la couche électriquement isolante (42), et/ou la métallisation (56) de la diode de protection (28) s'étend le long de la couche électriquement isolante (42) jusqu'au contact frontal (50) de la pile solaire (26).

4. Pile solaire selon au moins l'une des revendications précédentes,
**caractérisée en ce que**
le contact frontal (116) de la pile solaire (100) s'étend par zones le long de la couche électriquement isolante (42) et est relié directement à la métallisation (118) de la diode de protection (28), et/ou un connecteur électriquement isolant (60, 92, 120) relié à un contact de retour d'une autre pile solaire part du contact frontal (50) et/ou de la métallisation (90, 118).

5. Pile solaire selon au moins l'une des revendications précédentes,
**caractérisée en ce que**
la pile solaire (68) est une pile solaire à cascade comportant au moins des premières couches photoactives côté frontal et des deuxièmes couches photoactives côté substrat (82, 84, 78, 80), et entre les deuxièmes couches photoactives côté substrat et le substrat (70) s'étend la couche intermédiaire semi-conductrice (72) formant la couche semi-conductrice de diode ayant la polarité correspondant à la couche photoactive côté frontal, avec chaque fois une diode tunnel (88) disposée entre des paires de couches photoactives (82, 84 ; 78, 80) formant des piles solaires.

6. Pile solaire selon au moins l'une des revendications précédentes,
**caractérisée en ce que**
une diode tunnel (76) s'étend entre la couche intermédiaire semi-conductrice (74) formant la couche semi-conductrice de diode et le substrat pour un substrat (70) d'une polarité opposée à la polarité de la couche photoactive (84) côté frontal.

7. Pile solaire selon au moins l'une des revendications précédentes,
**caractérisée en ce que**
dans sa zone côté frontal, le substrat (102) de la pile solaire (100) présente un passage p/n (104) sur lequel s'étend la couche intermédiaire semi-conductrice (108) formant la couche semi-conductrice de diode, sur laquelle sont disposées, à l'extérieur de la diode de protection (28), une deuxième diode tunnel (118) et les couches photoactives (112, 114) disposées sur celle-ci.

8. Pile solaire selon au moins la revendication 1,
**caractérisée en ce qu'**
un premier connecteur (92) part de la diode de protection (28), un deuxième connecteur (60) part du contact frontal (50) de la pile solaire (68), le premier connecteur est relié au deuxième connecteur et est relié à la face arrière d'une autre pile solaire connectée en série avec la pile solaire.

9. Procédé de fabrication d'une pile solaire selon au moins l'une des revendications 1 à 8, comportant les étapes de procédé suivantes :
- croissance épitaxiale d'une couche intermédiaire semi-conductrice formant au moins une couche semi-conductrice de diode sur toute la zone côté frontal du substrat d'une polarité correspondant à la couche photoactive côté frontal de la pile solaire,
- croissance épitaxiale d'une diode tunnel sur la couche intermédiaire semi-conductrice,
- croissance épitaxiale des couches photoactives côtés substrat et frontal,
- dégagement de zones de la couche intermédiaire semi-conductrice,
- conformation de la diode de protection avec la polarité opposée à la pile solaire à l'aide d'une zone dégagée de la couche intermédiaire semi-conductrice, en déposant indirectement ou directement une métallisation sur celle-ci, puis connexion au contact frontal.

10. Procédé selon la revendication 9,
**caractérisé en ce qu'**
on dispose le contact frontal électriquement conducteur sur la couche photoactive côté frontal en particulier après le dégagement de zones de la couche intermédiaire semi-conductrice, la métallisation est de préférence reliée électriquement directement au contact frontal ou par un connecteur électriquement conducteur partant de celui-ci et relié à un contact arrière d'une autre pile solaire, et/ou on forme un palier, en particulier par gravure verticale, entre la zone à dégager de la couche intermédiaire semi-conductrice et les couches photoactives côtés frontal et substrat.

11. Procédé selon la revendication 9 ou 10,
**caractérisé en ce qu'**
on conçoit le long du palier une couche électriquement isolante, comme une couche anti-réflexion, s'étendant de la couche photoactive côté frontal jusqu'à la zone dégagée de la couche intermédiaire semi-conductrice.
